# EUROPÄISCHE PATENTANMELDUNG

(11) **EP 4 015 967 A1**
(43) Veröffentlichungstag der Anmeldung: **22.06.2022**
(21) Anmeldenummer: 20215036.3
(22) Anmeldetag: 17.12.2020
(51) Int. Cl.: F28D 15/02

(54) **HEATPIPEKÜHLKÖRPER FÜR EINEN PULSIERENDEN BETRIEB UND HERSTELLVERFAHREN FÜR EINEN DERARTIGEN HEATPIPEKÜHLKÖRPER**

(71) Anmelder: Siemens Aktiengesellschaft, 80333 München (DE)
(72) Erfinder: Müller, Volker, 90408 Nürnberg (DE); Neugebauer, Stephan, 91058 Erlangen (DE); Schwarz, Florian, 90766 Fürth (DE)

(57) **Zusammenfassung**

Die Erfindung betrifft einen Heatpipekühlkörper (1), wobei der Heatpipekühlkörper (1) für einen Betrieb als pulsierende Heatpipe eingerichtet ist, wobei der Heatpipekühlkörper (1) einen Körper (2) aufweist. Zur Verbesserung der Leistungsfähigkeit und Herstellbarkeit des Heatpipekühlkörpers (1) wird vorgeschlagen, dass der Körper (2) im Innern mindestens einen geschlossenen Kanal (3), insbesondere einen mäanderförmig ausgebildeten Kanal (3), aufweist, wobei der Körper (2) einen ersten Körperabschnitt (21) aufweist, der mäanderförmig oder U-förmig ausgebildeten ist, wobei der erste Körperabschnitt (21) von einem Kühlmedium (6) entlang der Oberfläche (4) des ersten Körperabschnitts (21) durchströmbar ist. Ferner betrifft die Erfindung ein Verfahren zur Herstellung eines derartigen Heatpipekühlkörpers (1), wobei in einem ersten Schritt der Körper (2) oder Blockteile (24) in einer Blockform hergestellt werden, wobei der Kanal (3) sich in einer Ebene erstreckt, wobei in einem zweiten Schritt der Körper (2) oder die Blockteile derart umgeformt oder gebogen werden, dass sich der erste Körperabschnitt (21) mit einer mäanderförmigen oder U-förmigen Struktur ergibt. Die Erfindung betrifft weiter eine Leistungshalbleitereinheit (10) und einen Stromrichter (30) mit einem derartigen Heatpipekühlkörper (1), wobei die entstehende Wärme mittels des Heatpipekühlkörpers (1) an das Kühlmedium (6) abführbar ist.

## Beschreibung

Die Erfindung betrifft einen Heatpipekühlkörper, wobei der Heatpipekühlkörper für einen Betrieb als pulsierende Heatpipe eingerichtet ist, wobei der Heatpipekühlkörper einen Körper aufweist. Ferner betrifft die Erfindung ein Verfahren zur Herstellung eines derartigen Kühlkörpers. Die Erfindung betrifft weiter eine Leistungshalbleitereinheit mit einem derartigen Heatpipekühlkörper und mindestens einem Leistungshalbleitermodul sowie einen Stromrichter mit einem derartigen Heatpipekühlkörper oder einer derartigen Leistungshalbleitereinheit.

Heatpipekühlkörper haben sich bereits seit Jahren für eine wirkungsvolle Kühlung auf dem Markt durchgesetzt. Dabei verdampft durch den Wärmeeintrag einer Wärmequelle in einem geschlossenen Rohr des Heatpipekühlkörpers eine Flüssigkeit. Durch das Vakuum im geschlossenen Rohr kondensiert die Flüssigkeit an einer anderen Stelle des Rohres, von der die Wärme dann beispielsweise an die Umgebungsluft abgegeben werden kann. Zum Zurückfließen der Flüssigkeit im Rohr wird der Kapillareffekt genutzt. Dafür wird die Innenseite des Rohres mit einer kapillaren Struktur versehen.

Bei dem Betrieb der pulsierenden Heatpipe, auch als oszillierende Heatpipe bezeichnet, wird die kapillare Struktur nicht benötigt. Die Innenseite des Rohres kann auch glatt ausgeführt sein. Auch bei der pulsierenden Heatpipe erfolgt der die Wärmeübertragung über eine Flüssigkeit, wobei Teile der Flüssigkeit gasförmig im Rohr vorhanden ist. Aufgrund des Wärmeeintrags beginnt die Flüssigkeit im Rohr sich hin- und her zu bewegen. Dieses Pulsieren gibt der Heatpipe seinen Namen.

Der Erfindung liegt die Aufgabe zugrunde, einen Heatpipekühlkörper insbesondere im Hinblick auf Leistungsfähigkeit der Kühlung und Herstellbarkeit zu verbessern.

Diese Aufgabe wird durch einen Heatpipekühlkörper gelöst, wobei der Heatpipekühlkörper für einen Betrieb als pulsierende Heatpipe eingerichtet ist, wobei der Heatpipekühlkörper einen Körper aufweist, wobei der Körper im Innern mindestens einen geschlossenen Kanal, insbesondere einen mäanderförmig ausgebildeten Kanal, aufweist, wobei der Körper einen ersten Körperabschnitt aufweist, der mäanderförmig oder U-förmig ausgebildeten ist, wobei der erste Körperabschnitt von einem Kühlmedium, insbesondere einem gasförmigen Kühlmedium, entlang der Oberfläche des ersten Körperabschnitts durchströmbar ist. Ferner wird diese Aufgabe durch eine Leistungshalbleitereinheit mit einem derartigen Heatpipekühlkörper und mindestens einem Leistungshalbleitermodul gelöst, wobei das Leistungshalbleitermodul thermisch leitend mit dem Heatpipekühlkörper derart verbunden ist, dass die durch Verlustleistung des Leistungshalbleitermoduls entstehende Wärme mittels des Heatpipekühlkörpers an das Kühlmedium, insbesondere an das gasförmige Kühlmedium oder an die Umgebungsluft, abführbar ist. Die Aufgabe wird weiter durch einen Stromrichter mit einem derartigen Heatpipekühlkörper oder einer derartigen Leistungshalbleitereinheit. Die Aufgabe wird ferner durch ein Verfahren zur Herstellung eines derartigen Heatpipekühlkörpers gelöst, wobei in einem ersten Schritt der Körper oder Blockteile in einer Blockform hergestellt werden, wobei der Kanal sich in einer Ebene erstreckt, wobei in einem zweiten Schritt der Körper oder die Blockteile derart umgeformt oder gebogen werden, dass sich der erste Körperabschnitt mit einer mäanderförmigen oder U-förmigen Struktur ergibt.

Weitere vorteilhafte Ausgestaltungen der Erfindung sind in den abhängigen Ansprüchen angegeben.

Der Erfindung liegt unter anderem die Erkenntnis zugrunde, dass die thermische Effizienz des ersten Körperabschnitts in einem Heatpipekühlkörper sehr stark von der Wärmeleitfähigkeit des verwendeten Materials abhängt. Die Integration einer pulsierenden Heatpipe in den ersten Körperabschnitt kann die Wärmeleitfähigkeit um ein Vielfaches erhöhen und damit deutlich die thermische Effizienz verbessern. Damit kann insbesondere bei besserer Kühlleistung auf teurere Materialien wie Kupfer verzichtet werden. Generell sind aber alle strukturell hinreichend stabilen (und umformbaren) Materialien denkbar, so z.B. auch elektrisch isolierende oder extrem korrosionsresistente oder verschleißunempfindliche Materialien. Vorzugsweise ist der Körper ein Aluminiumkörper oder ein Körper aus einem Kunststoff. Diese sind am Markt verfügbar, kostengünstig herstellbar und weisen eine hinreichend gute Wärmeleitfähigkeit auf.

Eine Herausforderung bei der Integration der pulsierenden Heatpipe in den ersten Körperabschnitt ist die kosteneffiziente Herstellung, um eine Anwendung in typischen Industrieanwendungen zu marktüblichen Preisen zu ermöglichen.

Der vorgeschlagene Ansatz ist, die einzelnen Körper mit dem ersten Körperabschnitt des Heatpipekühlkörpers aus nur einem Bauteil zu erzeugen. Dieses ist mit einer oder mehreren PHP-Strukturen versehen und abwechselnd beispielsweise mit größerem Radius (um 180°) gebogenen, so dass eine Art Schlangenform, Mäanderform oder U-Form entsteht, wobei hier die sich einstellenden Abstände zwischen den Biegungen beliebig variiert werden können und dabei auch die Größe des Heatpipekühlkörpers variiert werden kann. Alternativ kann es in vorgegebenen Abständen beispielsweise mit größerem Radius abwechseln zweimal um 90° nach rechts und zweimal 90° nach links gebogen werden, um ein ähnliches Ergebnis zu erzielen, bei dem die Kontaktfläche mit der Wärmequelle besser variiert werden kann.

Idealerweise wird der größte Teil, der Körper, des Heatpipekühlkörpers im ebenen Zustand (z.B. Präge-, Fräs- oder Rollprozess) oder bereits bei einem Extrusionsprozess erzeugt.

Ein nachträgliches Umformen des Körpers in seinem ersten Körperabschnitt führt dann zur endgültigen Kühlkörpergeometrie.

Zum Abschließen/Verbinden der PHP-Struktur können dann je nach Prozess noch Endstücke erzeugt werden. Dies kann beispielsweise mittels Bandverschweißen geschehen.

Die Endstücke können beispielsweise geprägt, gefräst, gebohrt, 3D-gedruckt, gespritzt und gegossen werden, insbesondere auch mit verlorener Form. Es sind sowohl additiv hinzugefügte Endstücke möglich wie auch die Integration des Endstücks in den Körper. Das Material kann bei additiv hinzugefügten Endstücken auch ein anderes als Aluminium sein. 3D-gedruckte oder mit verlorener Form gegossene Endstücke weisen hier ein Potenzial bei der hydraulischen Optimierung zur Performancesteigerung der pulsierenden Heatpipe auf.

Möglich ist auch, die Enden, insbesondere beide Enden, des Körpers mit nur einem Endstück zu verschließen und insbesondere gleichzeitig zu verbinden, um eine umlaufende PHP-Geometrie zu erreichen. Dies kann sich je nach Geometrie anbieten, um einen stabileren Betrieb des Heatpipekühlkörpers und/oder ein leichteres Anlaufen der pulsierenden Heatpipe zu ermöglichen.

Somit lässt sich eine hohe Leistungsfähigkeit und eine einfache Herstellbarkeit des Heatpipekühlkörpers dadurch erreichen, dass der Körper zuerst in einer Blockform mit innenliegenden mäanderförmigen Kühlkanälen erzeugt wird. Unter eine Blockform ist ein Polygonkörper zu verstehen, der mäanderförmig umgeformt oder gebogen werden kann. Ein Beispiel für eine solche Blockform ist ein Quader. Dabei muss eine solche Blockform oder ein solcher Quader nicht notwendigerweise ebene Flächen als Ränder aufweisen. Auch müssen diese nicht paarweise parallel zueinander sein. Dies wird im folgenden mit den Worten beschrieben, dass der Block im Wesentlichen einem Quader entspricht oder im Wesentlichen in Quaderform ausgeführt ist, da der Körper nicht notwendigerweise ebene Flächen als Ränder oder paarweise parallele Oberflächen aufweisen muss. Um beispielsweise einen besseren Wärmeübergang an das Kühlmedium zu erzeugen, kann die Oberfläche gegenüber einer ebenen Form erhöht werden. Dies kann beispielsweise durch eine Wellenform, insbesondere an Teilen des Körpers, die für die Bildung des ersten Körperabschnitts vorgesehen sind, geschehen. Darüber hinaus ist auch eine Aufrauhung der Oberfläche durch herausstehende oder hineinrechende Elemente möglich. In einem nächsten Schritt wird dieser Körper derart umgeformt oder gebogen, dass dieser in dem ersten Körperabschnitt eine mäanderförmige oder U-Förmige Ausgestaltung erhält. Dabei kann der Körper beispielsweise in 90° oder 180° Bögen gebogen werden. Darüber hinaus ist es auch beispielsweise möglich, den Alukörper in 270° Bögen zu biegen, wobei sich dann vorteilhafterweise diese Bögen mit unterschiedlicher Richtung direkt aneinander anschließen. Dieser erster Körperabschnitt mit mäanderförmiger oder U-förmiger Ausgestaltung kann von einem Kühlmedium, wie beispielsweise Luft durchströmt werden. Dadurch kann eine leistungsfähige Kühlung erzielt werden.

Bei einer vorteilhaften Ausgestaltung der Erfindung weist der Heatpipekühlkörper am ersten Körperabschnitt Kühlrippen auf. Durch die Anordnung von Kühlrippen an die Oberfläche des Körpers, insbesondere im Bereich des ersten Körperabschnitts, kann die Wärmeabgabe vom Heatpipekühlkörper an das Kühlmedium, das an dem ersten Körperabschnitt entlangströmt, noch besser und wirkungsvoller abgegeben werden. Insbesondere bei kleinen Temperaturunterschieden zwischen dem Heatpipekühlkörper und dem Kühlmedium wie beispielsweise Luft kann der Wärmeübergang deutlich verbessert werden.

Bei einer weiteren vorteilhaften Ausgestaltung der Erfindung weist der Heatpipekühlkörper mindestens zwei Körper auf. Es hat sich als vorteilhaft erwiesen, den Heatpipekühlkörper modular mit einer Vielzahl von Körpern, also mindestens zwei Körpern aufzubauen. Dabei können die Körper gleich ausgebildet sein oder sich unterscheiden. Dadurch wird die Kühlung redundant gestaltet. Selbst beim Ausfall der Kühlwirkung eines Körpers, beispielsweise durch eine Undichtigkeit im Kanal, wird durch die übrigen Körper eine hinreichende Kühlung weiterhin sichergestellt. Ebenso ist es möglich, Heatpipekühlkörper mit unterschiedlicher Leistungsfähigkeit herzustellen, indem eine unterschiedliche Anzahl gleicher Körper zur Bildung des Heatpipekühlkörpers zur Anwendung kommen. Mit anderen Worten weist der Heatpipekühlkörper eine Vielzahl gleicher Körper auf. Dabei ergibt sich die Anzahl der Körper in Abhängigkeit von der Leistungsfähigkeit des Heatpipekühlkörpers. Damit lassen sich eine Vielzahl von Heatpipekühlkörpern mit unterschiedlicher Leistungsfähigkeit kostengünstig herstellen.

Bei einer weiteren vorteilhaften Ausgestaltung der Erfindung sind die Körper aus Sicht des durchströmenden Kühlmediums hintereinander angeordnet. Bei dieser Anordnung können die Körper auf einfache Weise aneinander befestigt werden, da sie aus gleichem Material (Aluminium) sind und damit auch der gleichen Ausdehnung bei Erwärmung unterliegen. Ermüdungserscheinungen aufgrund unterschiedlicher Ausdehnung wird damit zuverlässig vermieden und der Heatpipekühlkörper erzielt eine hohe Lebensdauer.

Bei einer weiteren vorteilhaften Ausgestaltung der Erfindung weist der Heatpipekühlkörper eine Bodenplatte auf, wobei die Bodenplatte mit dem Körper wärmeleitend verbunden ist, wobei die Bodenplatte für die Verbindung mit einer Wärmequelle vorgesehen ist. Die Bodenplatte kann dabei derart ausgelegt werden, dass die Wärmequelle, beispielsweise ein Halbleiter, bei höheren Leistungen und damit einhergehenden Verlustleistungen auch als Leistungshalbleiter bezeichnet, sicher an der Bodenplatte des Heatpipekühlkörpers befestigt werden kann. Gleichzeitig erfolgt durch die Bodenplatte eine Wärmespreizung, so dass die Wärme gleichmäßig an den Körper übertragen wird. Dabei kann die Bodenplatte Ausnehmungen aufweisen, die einen Teil des mäanderförmigen oder U-förmigen Körperabschnitts des ersten Bereichs des Körpers aufnehmen können. Durch die Vergrößerung der Kontaktfläche zwischen Körper und Bodenplatte wird der Wärmeübertrag zwischen Bodenplatte und Körper verbessert und die Leistungsfähigkeit des Heatpipekühlkörpers nimmt zu. Die Bodenplatte und der Körper können beispielsweise mittels Lötens, Schweißen, Kleben, Klemmen, Verpressen oder einem anderen Verfahren dauerhaft miteinander verbunden werden.

Bei einer weiteren vorteilhaften Ausgestaltung der Erfindung ist der erste Körperabschnitt U-förmig ausgebildet, wobei der erste Körperabschnitt mit einem Abschlussteil derart verbunden ist, dass sich ein ringförmiger Körper ergibt. Durch diese Ausgestaltung kann eine Vielzahl von unabhängigen Kühlkanälen in einem Heatpipekühlkörper erzeugt werden. Damit weist ein derartig aufgebauter Heatpipekühlkörper eine hohe Redundanz auf. Die ringförmigen Körper des Heatpipekühlkörpers können darüber hinaus auf einfache Weise von Kühlluft durchströmt werden. Darüber hinaus kann der erste Teil des Körpers auf einfache Weise durch nur einen Biegevorgang erzeugt werden.

Unter der Ringform ist eine geschlossene Form zu verstehen. Darunter fallen beispielsweise eine Kreisform, eine Ovalform oder auch zwei parallel Anschnitte, die an ihren Enden durch Halbkreisförmige Abschnitte geschlossen werden.

Bei einer weiteren vorteilhaften Ausgestaltung der Erfindung weist der Körper einen zweiten Körperabschnitt auf, der eine ebene Oberfläche aufweist, wobei die Oberfläche für die Verbindung mit einer Wärmequelle vorgesehen ist. Bei dieser Ausgestaltung ist die Wärmequelle besonders nahe an den Kanal des Körpers angeordnet ist. Durch die Nähe zu diesem Kanal kann die hocheffiziente Kühlung der Heatpipe besonders gut genutzt werden. Hohe Wärmemengen können ohne nennenswerten Zeitverzug von der Wärmequelle wegtransportiert werden. Zudem kann der Heatpipekühlkörper aus nur wenigen Teilen aufgebaut werden. Im einfachsten Fall besteht der Heatpipekühlkörper nur aus dem Körper mit einem ersten Bereich für das Durchströmen der Kühlluft und einem zweiten Bereich für die Anordnung der Wärmequelle. Damit ist auf einfache Weise ein leistungsfähiger und leichter Kühlkörper auf kostengünstige Weise herstellbar.

Weiterhin sind mit ringförmig geschlossenen ersten Körperabschnitte auch Strömungen innerhalb des Kanals mit Vorzugsrichtung möglich. Hier bietet sich unter anderem auch die Verwendung eines muffenartig ausgebildeten Verbindungsstückes an. Diese Muffe charakterisiert sich durch einen umlaufenden Kragen, der die genaue Positionierung der zwei offenen Enden des U-förmig ausgeformten Bereichs des Körpers sowohl genau positioniert als auch mechanisch vor Verschieben sichert. Die Verbindungsmuffe beinhaltet vorzugsweise den Befüll- und Verschlussmechanismus.

Bei einer weiteren vorteilhaften Ausgestaltung der Erfindung wird der Körper aus mindestens zwei Blockteilen zusammengesetzt. Das Fertigen des Kanals lässt sich auf einfache Weise durchführen, wenn der Körper sich aus zwei Blockteilen zusammensetzt. Dann können Teile des Kanals jeweils an einer Grenzfläche der Blockteile angeordnet werden. Anschließend kann beispielsweise durch Löten, Schweißen, Kleben, Klemmen, Verpressen oder einem anderen Verfahren der Körper aus den Blockteilen gebildet werden. So lässt sich der Kühlkanal auf besonders einfache Weise in den Körper einbringen.

Dabei können bei der Herstellung des Körpers aus zwei Blockteilen zuerst die beiden Blockteile zum Körper verbunden werden oder alternativ können erst die Blockteile umgeformt oder gebogen werden und anschließend zu einem Körper verbunden werden.

Bei einer weiteren vorteilhaften Ausgestaltung der Erfindung wird der Körper in Blockform mittels eines Stranggussverfahrens hergestellt. Das Stranggussverfahren hat sich als kostengünstiges Herstellverfahren für Körper erwiesen. Ein Ansatz ist hierbei die zumindest die teilweise Herstellung des Körpers und der dazugehörigen inneren Struktur der pulsierenden Heatpipe mittels Strangpressen. Wenn allerdings nur einzelne U-förmig, ausgebildete erste Körperabschnitte des Körpers vorgesehen sind, müssen diese dann wiederum alle an beiden Enden Verbindungsstrukturen aufweisen, um die interne Kühlstruktur der oszillierenden Heatpipe abzuschließen, was wiederum zu erhöhten Kosten führen kann. Hierbei ist Aluminium am besten geeignet, welches bei Kühlkörpern derzeit in der Regel auch das beste Kosten-Nutzen-Verhältnis aufweist. Bei einigen Anwendungen ist hier aber auch die Anwendung von Kunststoff alternativ denkbar.

Bei einer weiteren vorteilhaften Ausgestaltung der Erfindung wird der Körper gefräst, gedrückt oder gepresst, insbesondere wird der Kanal in die zwei Blockteile gefräst, gedrückt oder gepresst. Auch das Fräsen ist eine einfache Fertigungsmethode. Gerade für die Fertigung des Körpers aus zwei Blockteile bietet sich das Fräsen zum Einbringen des Kanals in die beiden Blockteile an. Die einzelnen Blockteile können in einem ersten Schritt als identischer Block hergestellt werden. In einem zweiten Schritt wird die Struktur des Kanals in die Blockteile gefräst, gedrückt oder gepresst. Dabei kann das Fräsen der Kanalanteile und damit die Ausbildung des Kanals beispielsweise abhängig von der Ausbildung der Wärmequelle unterschiedlich gestaltet werden.

Im Folgenden wird die Erfindung anhand der in den Figuren dargestellten Ausführungsbeispiele näher beschreiben und erläutert. Es zeigen:
- FIG 1 bis FIG 4: Ausführungsbeispiele von Heatpipekühlkörpern und Leistungshalbleitereinheiten,
- FIG 5 bis FIG 7: Ausführungsbeispiel eines Körpers,
- FIG 8 bis FIG 14: Ausführungsbeispiele von Heatpipekühlkörpern und
- FIG 15: einen Stromrichter.

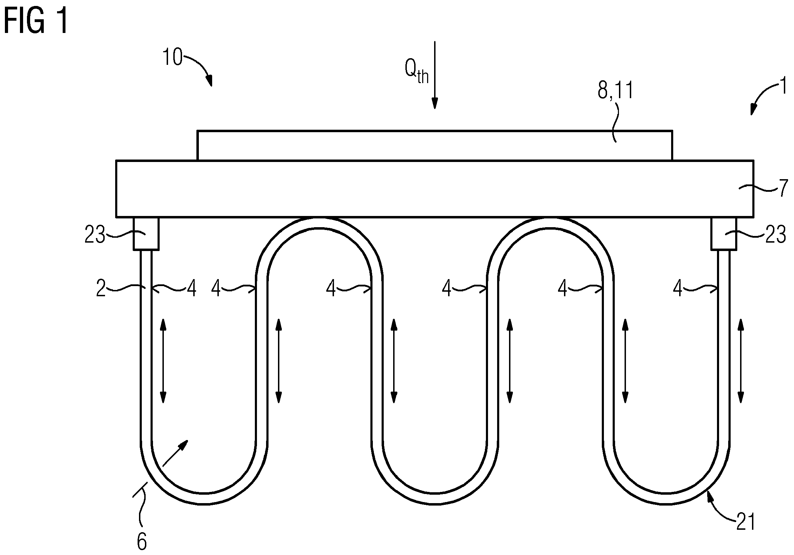

Die FIG 1 zeigt einen Heatpipekühlkörper 1, der einen Körper 2 und eine Bodenplatte 7 aufweist. An der Bodenplatte 7 ist eine Wärmequelle 8 angeordnet, die eine Wärmemenge Qₜₕ in den Heatpipekühlkörper 1 einbringt. Sofern es sich bei der Wärmequelle 8 um eine Leistungshalbleitermodul 11 handelt, wird die Kombination aus Heatpipekühlkörper 1 und Leistungshalbleitermodul 11 als Leistungshalbleitereinheit 10 bezeichnet. Der Körper 2 weist im Wesentlichen einen mäanderförmig geformten ersten Körperabschnitt 21 auf. Entlang der Oberfläche 4 des ersten Körperabschnitts 21 strömt ein Kühlmedium 6, insbesondere ein gasförmiges Kühlmedium 6 wie beispielsweise Luft. Dieses Kühlmedium 6 ist mit Hilfe eines Pfeils in der vorliegenden FIG dargestellt. Abgeschlossen ist der Körper 2 mit einem Abschlussteil 23. Das Abschlussteil 23 kann vorteilhafterweise auch zum Befüllen eines hier nicht näher dargestellten Kanals 3 genutzt werden.

Das pulsierende Flüssigkeits-Gas Gemisch im Innern des Kanals 3 des Heatpipekühlkörpers 1 ist durch die senkrechten Pfeile mit den beiden Pfeilspitzen angedeutet.

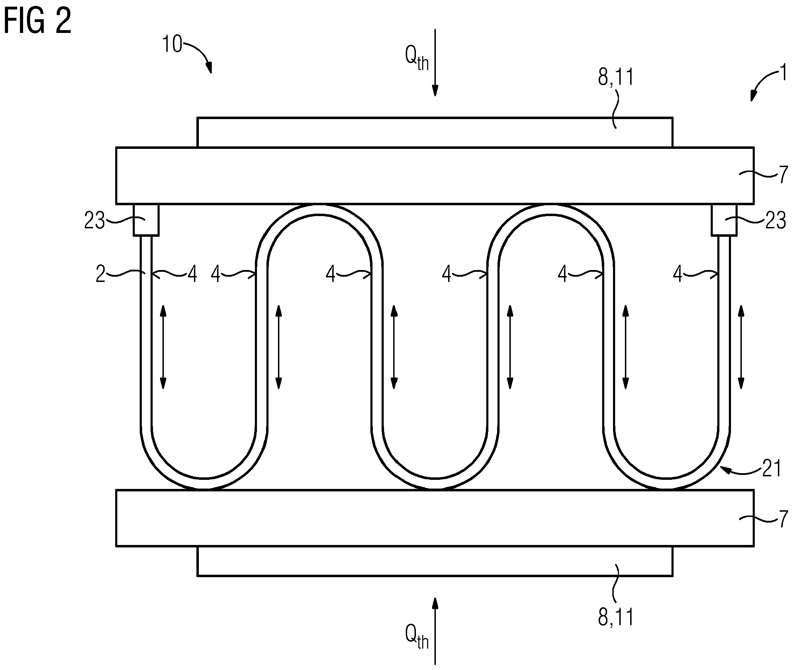

Die FIG 2 zeigt ein weiteres Ausführungsbeispiel eines Heatpipekühlkörpers 1 bzw. einer Leistungshalbleitereinheit 10. Dieses Heatpipekühlkörper 1 weist zwei Bodenplatten 7 auf, an denen jeweils eine Wärmequelle 8 bzw. ein Leistungshalbleitermodul 11 angeordnet ist, die oder das eine Wärmemenge Qₜₕ in den Heatpipekühlkörper 1 einbringt. Zur Vermeidung von Wiederholungen wird auf die Beschreibung zur FIG 1, sowie auf die dort eingeführten Bezugszeichen verwiesen. Auch hier durchströmt das Kühlmedium 6 den Heatpipekühlkörper 1 entlang der Oberfläche 4 des ersten Körperabschnitts 21 des Körpers 2, jedoch ist dies in dieser und den folgenden Figuren nicht weiter mittels des Pfeils und dem dazugehörigen Bezugszeichen dargestellt.

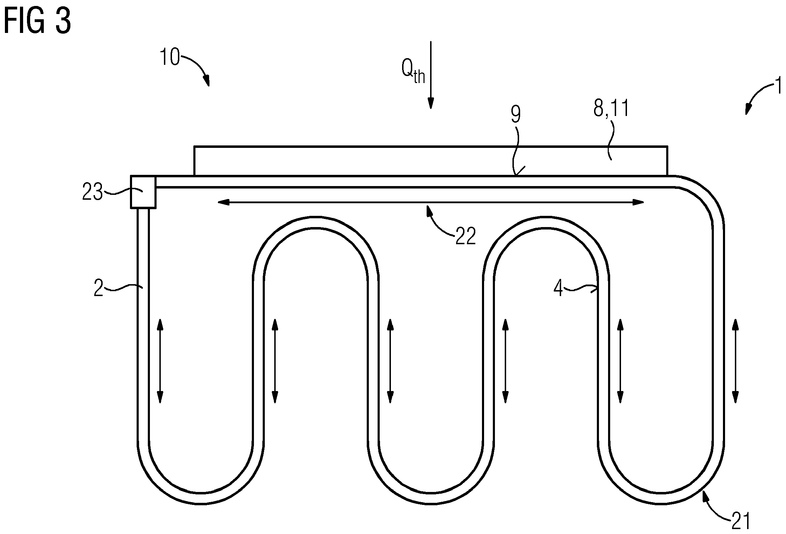

Die FIG 3 zeigt ein weiteres Ausführungsbeispiel eines Heatpipekühlkörpers 1. Dieser Heatpipekühlkörper 1 umfasst keine Bodenplatte 7. Der Heatpipekühlkörper 1 ist somit bodenplattenfrei ausgeführt. Der Körper weist neben dem ersten Körperabschnitt 21 mit mäanderförmiger Ausbildung einen zweiten Körperabschnitt 22 mit einer ebenen Oberfläche 9 auf. An der ebenen Oberfläche 9 des zweiten Körperabschnitts 22 ist die Wärmequell 8 bzw. das Leistungshalbleitermodul 11 angeordnet. Zur Vermeidung von Wiederholungen wird auf die Beschreibung zu FIG 1 und FIG 2, sowie auf die dort eingeführten Bezugszeichen verwiesen.

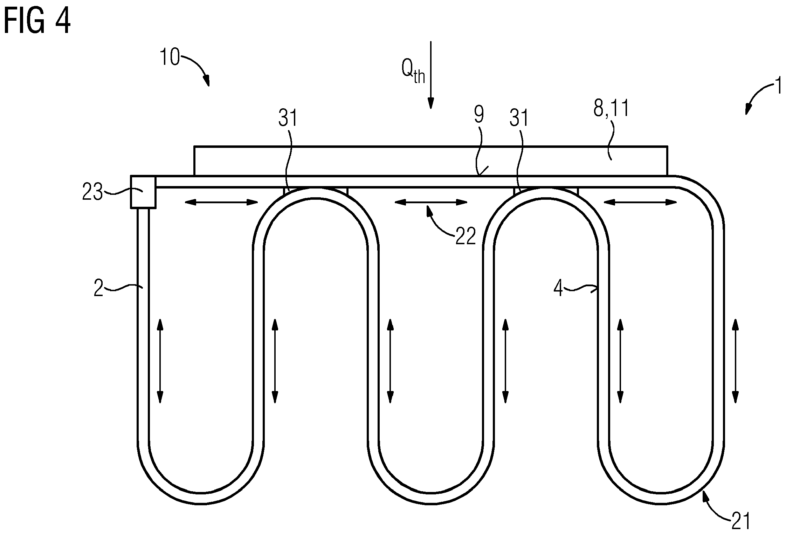

Die FIG 4 zeigt ein weiteres Ausführungsbeispiel eines Heatpipekühlkörpers 1. Dieser Heatpipekühlkörper 1 weist zwischen dem ersten Körperabschnitt 21 und dem zweiten Körperabschnitt 22 Verbindungen 31 zwischen dem ersten Körperabschnitt 21 und dem zweiten Körperabschnitt 22 auf. Mit diesen Verbindungen 31 wird die Wärmemenge Qₜₕ von der Wärmequelle 8, die in den zweiten Körperabschnitt 22 des Körpers 2 eingebracht wird, noch besser an den ersten Körperabschnitt 21 des Körpers 2, bei dem der Übergang an das Kühlmedium bzw. das gasförmige Kühlmedium erfolgt, übertragen. Zur Vermeidung von Wiederholungen wird auf die Beschreibung zu den Figuren 1 bis 3, sowie auf die dort eingeführten Bezugszeichen verwiesen.

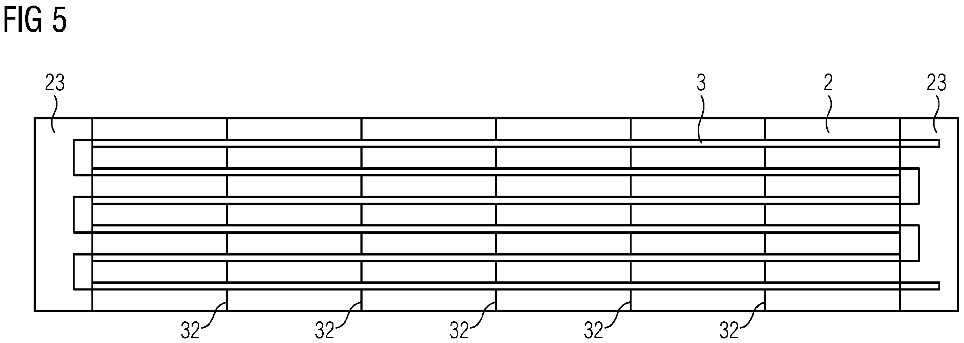

Die FIG 5 zeigt ein Ausführungsbeispiel eines Körpers 2. Dieser Körper 2 hat eine blockförmige Ausgestaltung. Innerhalb des Körpers 2 befindet sich ein Kanal 3. In diesem Kanal 3 liegt ein Fluid in zwei Phasen vor, mit dem die Wirkungsweise der Heatpipe, insbesondere der pulsierende Heatpipe, realisiert wird. Zum Abschluss und ggf. Befüllen des Kanals dienen Abschlussteile 23 des Körpers 2. Im Rahmen der Herstellung des Heatpipekühlkörpers 1 wird der Körper 2 an den Biegestellen 32 in eine Mäanderform oder U-Form umgeformt. Der Bereich des Körpers 2, der mäanderförmig oder U-förmig ausgebildet ist, bildet dann den ersten Körperabschnitt 21, der zum Übergang der Wärme an das Kühlmedium 6 dienst. Zur Vermeidung von Wiederholungen wird auf die Beschreibung zu den Figuren 1 bis 4, sowie auf die dort eingeführten Bezugszeichen verwiesen.

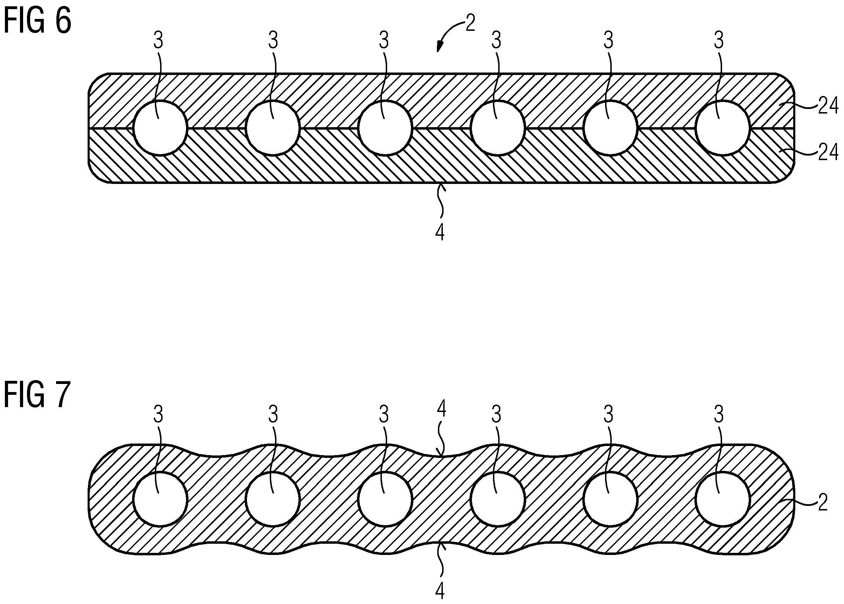

Die FIG 6 zeigt den Körper 2 der FIG 5 in einem anderen Schnitt. Darüber hinaus gliedert sich der Körper 2 in zwei Blockteile 24, die im Rahmen der Herstellung miteinander zu dem Körper 2 verbunden werden. Zur Vermeidung von Wiederholungen wird auf die Beschreibung zu den Figuren 1 bis 5, sowie auf die dort eingeführten Bezugszeichen verwiesen. Der Körper 2 weist im Innern den Kanal 3 auf. Aus der blockförmigen Ausgestaltung des Körpers 2 ergibt sich die im Wesentlichen rechteckförmige Schnittfläche. Um jedoch die Oberfläche 4 des ersten Körperabschnitts 21 zu erhöhen und damit den Wärmeübergang vom Heatpipekühlkörper an das Kühlmedium 6 zu verbessern, kann der Körper an seiner Oberfläche, insbesondere an der Oberfläche 4 des ersten Körperabschnitts 21 eine wellenartige Oberfläche aufweisen, wie sie in FIG 7 gezeigt ist. Alternativ ist auch eine Sägezahnform oder Dreieckform möglich. Auch diese verbessern den Wärmeübergang vom Heatpipekühlkörper 1 an das Kühlmedium 6 und somit die Leistungsfähigkeit des Heatpipekühlkörpers. Zur Vermeidung von Wiederholungen wird auf die Beschreibung zu den Figuren 1 bis 6, sowie auf die dort eingeführten Bezugszeichen verwiesen.

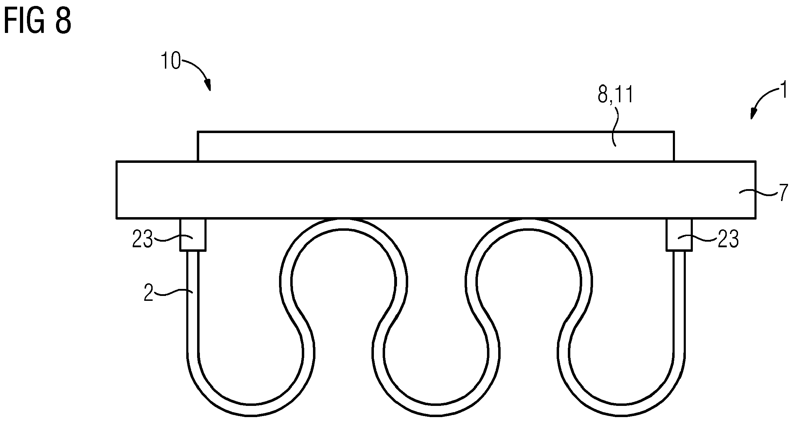

Die FIG 8 zeigt ein weiteres Ausführungsbeispiel eines Heatpipekühlkörpers 1 bzw. einer Leistungshalbleitereinheit 10. Zur Vermeidung von Wiederholungen wird auf die Beschreibung zu den Figuren 1 bis 7, sowie auf die dort eingeführten Bezugszeichen verwiesen. Der mäanderförmige Teil weist dabei Biegungen auf, die über einen Winkel von 180° hinausgehen. Beispielsweise können diese einen Bereich 270° aufweisen, wobei sich entgegengesetzte Biegungen direkt aneinander anschließen und keinen geraden Abschnitt aufweisen. Dadurch kann die für den Wärmeübergang vom Heatpipekühlkörper 1 an das Kühlmedium 6 wirksame Oberfläche 4 des ersten Körperabschnitts 21 weiter erhöht werden. Dies verbessert die Leistungsfähigkeit des Heatpipekühlkörpers 1 weiter.

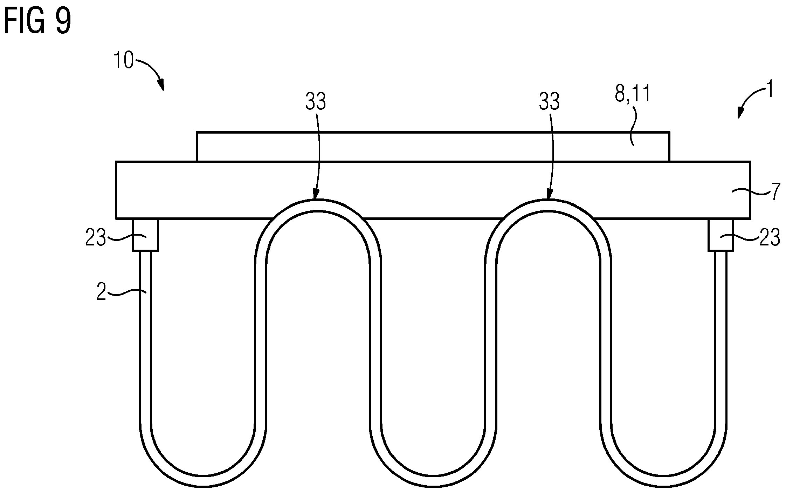

Die FIG 9 zeigt ein weiteres Ausführungsbeispiel eines Heatpipekühlkörpers 1 bzw. einer Leistungshalbleitereinheit 10. Zur Vermeidung von Wiederholungen wird auf die Beschreibung zu den Figuren 1 bis 8, sowie auf die dort eingeführten Bezugszeichen verwiesen. Die Bodenplatte 7 dieses Ausführungsbeispiels weist Ausnehmungen 33 auf. Diese Ausnehmungen 33 sind derart ausgebildet, um einen Teil des ersten Körperabschnitts 21 des Körpers 2 aufnehmen. Dabei hat es sich als vorteilhaft erwiesen. Die Ausnehmungen 33 mit einer gebogenen Grenzfläche gegenüber der Bodenplatte 7 auszuführen. Dadurch kann der Körper 2 an der Bodenplatte 7 anliegen. Durch die Ausnehmung 33 vergrößert sich der für den Wärmeübergang zwischen Bodenplatte 7 und Körper 2 wirksame Oberfläche. Diese Vergrößerung der wirksamen Oberfläche führt zu einer verbesserten Leistungsfähigkeit des Heatpipekühlkörpers 1.

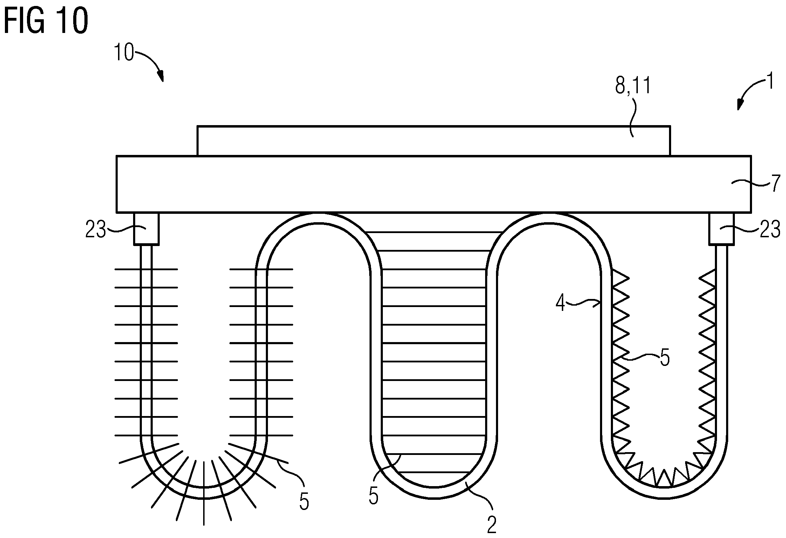

Die FIG 10 zeigt ein weiteres Ausführungsbeispiel eines Heatpipekühlkörpers 1 bzw. einer Leistungshalbleitereinheit 10. Zur Vermeidung von Wiederholungen wird auf die Beschreibung zu den Figuren 1 bis 9, sowie auf die dort eingeführten Bezugszeichen verwiesen. An dem Körper 2 im ersten Körperabschnitt 21 sind dabei Kühlrippen 5 angeordnet. Diese werden oftmals auch als Fins oder Pins bezeichnet. Sie können als Stäbe, oder in einer dreieckförmigen Struktur an der Oberfläche 4 des ersten Körperabschnitts 21 angeordnet sein. Ebenso ist es möglich, wie in der Mitte dargestellt, die Kühlrippen zwischen zwei Bereichen des ersten Körperabschnitts 21 anzuordnen.

Als besonders vorteilhaft hat es sich herausgestellt, wenn die Kühlrippen 5 parallel zur Bodenplatte 7 oder parallel zum zweiten Körperabschnitt 21 verlaufen. Dann ist die Erwärmung in den Kühlrippen 5 besonders homogen und es entstehen keine mechanischen Spannungen aufgrund inhomogener Erwärmung von Teilen des Heatpipekühlkörpers 1.

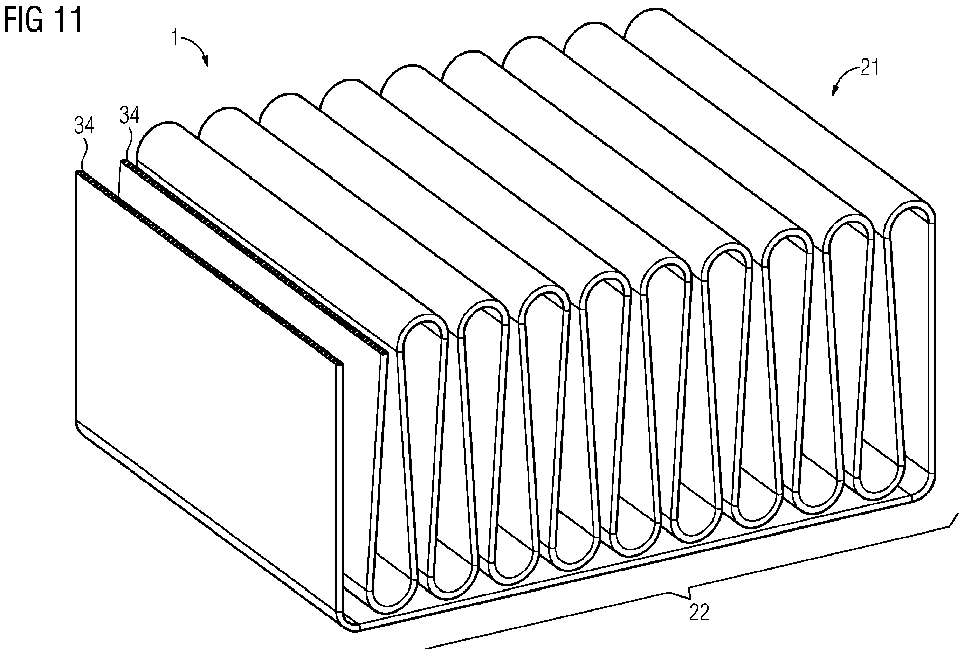

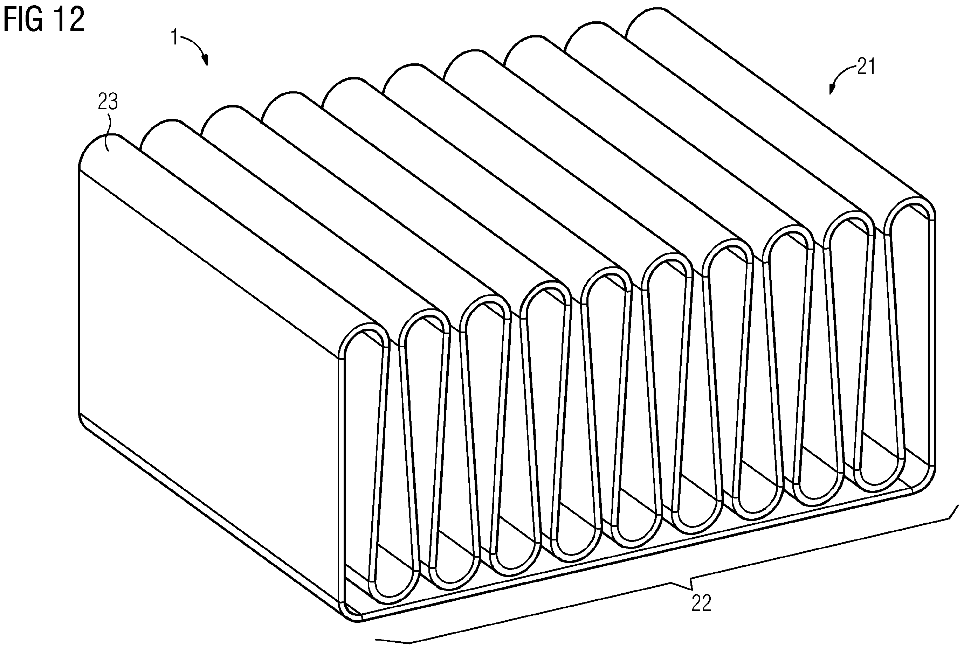

Die FIG 11 zeigt ein weiteres Ausführungsbeispiel eines Heatpipekühlkörpers 1, der ohne Bodenplatte 7 ausgeführt ist. Zur Vermeidung von Wiederholungen wird auf die Beschreibung zu den Figuren 1 bis 10, sowie auf die dort eingeführten Bezugszeichen verwiesen. An dem zweiten Körperabschnitt kann die Wärmequelle 8 angeordnet werden. Dabei weist der Heatpipekühlkörper zwei offene Enden 34 auf. Schließt man diese offenen Enden 34 mit Hilfe eines Abschlussteils 23, so erhält der Körper 2 eine geschlossene Form. Dies ist in FIG 12 dargestellt. Zur Vermeidung von Wiederholungen wird auf die Beschreibung zu den Figuren 1 bis 11, sowie auf die dort eingeführten Bezugszeichen verwiesen.

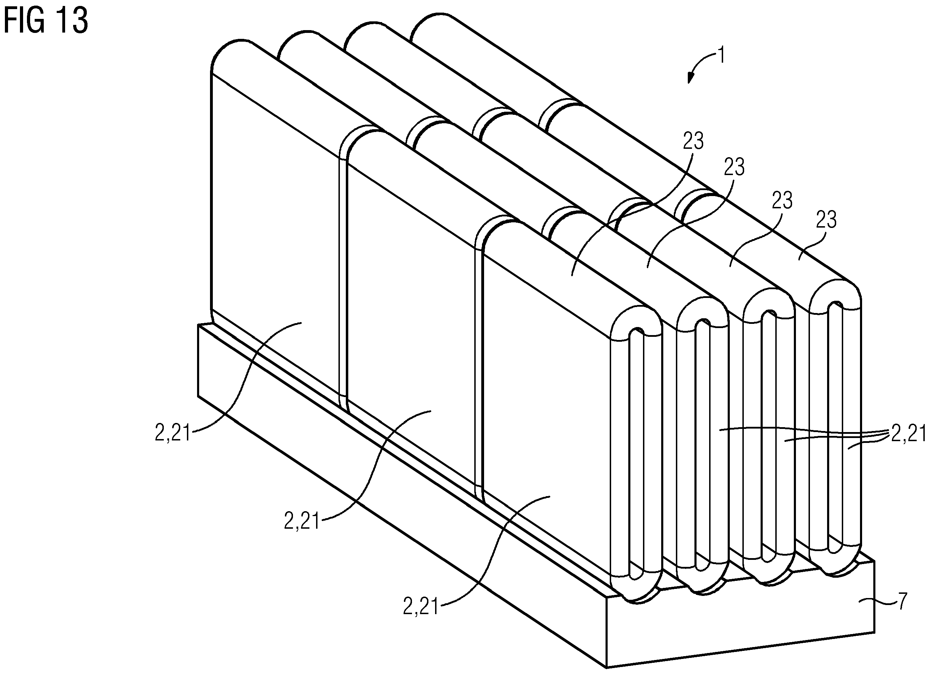

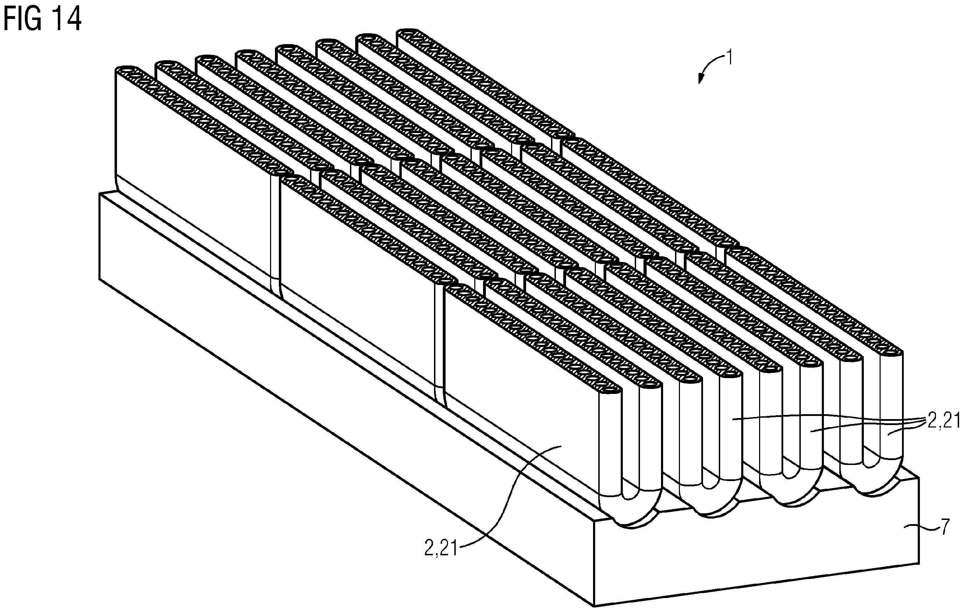

Die FIG 13 zeigt ein weiteres Ausführungsbeispiel eines Heatpipekühlkörpers 1. Zur Vermeidung von Wiederholungen wird auf die Beschreibung zu den Figuren 1 bis 12, sowie auf die dort eingeführten Bezugszeichen verwiesen. Dieser Heatpipekühlkörper 1 weist eine Vielzahl von Körpern 2 auf. Diese sind in diesem Ausführungsbeispiel U-förmig ausgestaltet. Durch ein Abschlussteil 23 ergibt sich eine Kreisform, die von dem Kühlmedium 6, insbesondere dem gasförmigen Kühlmedium 6, durchströmt werden kann. Die Körper sind mit der Bodenplatte 7 verbunden, die unter anderem eine Ausrichtung der Körper untereinander gewährleistet. Alternativ kann der erste Körperbereich auch mäanderförmig ausgestaltet sein. Damit ist auch die Verwendung einer Vielzahl von mäanderförmig ausgestalteten ersten Bereichen 21 des Körpers 2 bei der Verwendung einer Vielzahl von Körpern 2 für die Bildung eines Heatpipekühlkörpers 1 möglich. Eine Anordnung ohne Abschlussteile 23 zeigt FIG 14, aus der die U-förmige Ausgestaltung der Körper 2 ersichtlich ist.

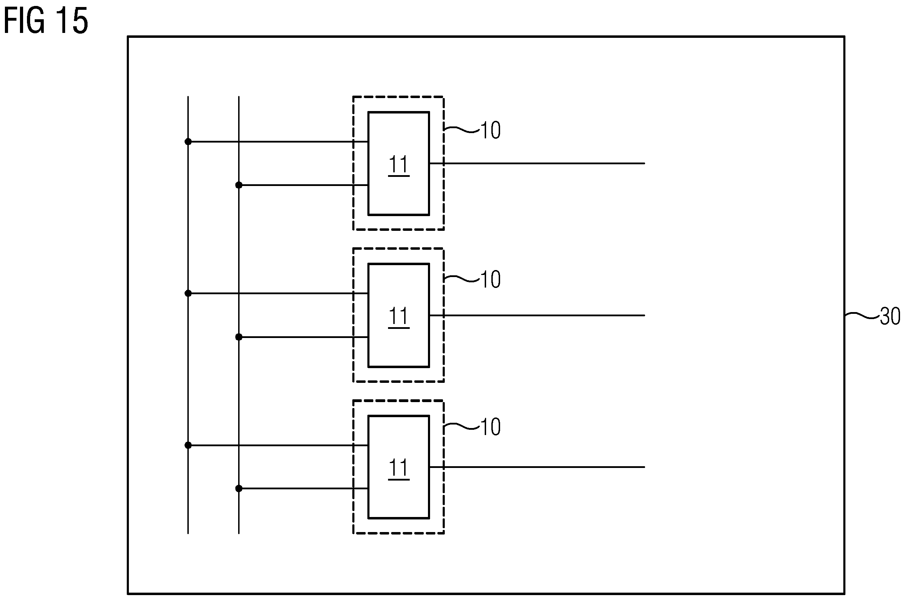

Die FIG 15 zeigt einen Stromrichter 30 mit drei Leistungshalbleitereinheiten 10. Die Leistungshalbleitereinheiten 10 weisen jeweils mindestens ein Leistungshalbleitermodul 11 auf. Das Leistungshalbleitermodul wird mittels eines hier nicht näher dargestellten Heatpipekühlkörpers 1 gekühlt bzw. entwärmt. Dabei kann der Heatpipekühlkörper 1 gemäß einer der zuvor erläuterten Figuren ausgebildet sein.

Zusammenfassend betrifft die Erfindung einen Heatpipekühlkörper, wobei der Heatpipekühlkörper für einen Betrieb als pulsierende Heatpipe eingerichtet ist, wobei der Heatpipekühlkörper einen Körper aufweist. Zur Verbesserung der Leistungsfähigkeit und Herstellbarkeit des Heatpipekühlkörpers wird vorgeschlagen, dass der Körper im Innern mindestens einen geschlossenen Kanal, insbesondere einen mäanderförmig ausgebildeten Kanal, aufweist, wobei der Körper einen ersten Körperabschnitt aufweist, der mäanderförmig oder U-förmig ausgebildeten ist, wobei der erste Körperabschnitt von einem Kühlmedium, insbesondere einem gasförmigen Kühlmedium, entlang der Oberfläche des ersten Körperabschnitts durchströmbar ist. Ferner betrifft die Erfindung ein Verfahren zur Herstellung eines derartigen Heatpipekühlkörpers, wobei in einem ersten Schritt der Körper oder Blockteile in einer Blockform hergestellt werden, wobei der Kanal sich in einer Ebene erstreckt, wobei in einem zweiten Schritt der Körper oder die Blockteile derart umgeformt oder gebogen werden, dass sich der erste Körperabschnitt mit einer mäanderförmigen oder U-förmigen Struktur ergibt. Die Erfindung betrifft weiter eine Leistungshalbleitereinheit und einen Stromrichter mit einem derartigen Heatpipekühlkörper, wobei die entstehende Wärme mittels des Heatpipekühlkörpers an das Kühlmedium abführbar ist.

## Patentansprüche

1. Heatpipekühlkörper (1), wobei der Heatpipekühlkörper (1) für einen Betrieb als pulsierende Heatpipe eingerichtet ist, wobei der Heatpipekühlkörper (1) einen Körper (2) aufweist, wobei der Körper (2) im Innern mindestens einen geschlossenen Kanal (3), insbesondere einen mäanderförmig ausgebildeten Kanal (3), aufweist, wobei der Körper (2) einen ersten Körperabschnitt (21) aufweist, der mäanderförmig oder U-förmig ausgebildeten ist, wobei der erste Körperabschnitt (21) von einem Kühlmedium (6), insbesondere einem gasförmigen Kühlmedium (6), entlang der Oberfläche (4) des ersten Körperabschnitts (21) durchströmbar ist.

2. Heatpipekühlkörper (1) nach Anspruch 1, wobei der Heatpipekühlkörper (1) am ersten Körperabschnitt (21) Kühlrippen (5) aufweist.

3. Heatpipekühlkörper (1) nach einem der Ansprüche 1 oder 2, wobei der Heatpipekühlkörper (1) mindestens zwei Körper (2) aufweist.

4. Heatpipekühlkörper (1) nach Anspruch 3, wobei die Körper (2) aus Sicht des durchströmenden Kühlmediums (6) hintereinander angeordnet sind.

5. Heatpipekühlkörper (1) nach einem der Ansprüche 1 bis 4, wobei der Heatpipekühlkörper (1) eine Bodenplatte (7) aufweist, wobei die Bodenplatte (7) mit dem Körper (2) wärmeleitend verbunden ist, wobei die Bodenplatte (7) für die Verbindung mit einer Wärmequelle (8) vorgesehen ist.

6. Heatpipekühlkörper (1) nach einem der Ansprüche 1 bis 5, wobei der erste Körperabschnitt (21) U-förmig ausgebildet ist, wobei der erste Körperabschnitt (21) mit einem Abschlussteil (23) derart verbunden ist, dass sich ein ringförmiger Körper ergibt.

7. Heatpipekühlkörper (1) nach einem der Ansprüche 1 bis 4, wobei der Körper (2) einen zweiten Körperabschnitt (22) aufweist, der eine ebene Oberfläche (9) aufweist, wobei die Oberfläche (9) für die Verbindung mit einer Wärmequelle (8) vorgesehen ist.

8. Leistungshalbleitereinheit (10) aufweisend
- einen Heatpipekühlkörper (1) nach einem der Ansprüche 1 bis 7 und
- mindestens ein Leistungshalbleitermodul (11),
wobei das Leistungshalbleitermodul (11) thermisch leitend mit dem Heatpipekühlkörper (1) derart verbunden ist, dass die durch Verlustleistung des Leistungshalbleitermoduls (11) entstehende Wärme mittels des Heatpipekühlkörpers (1) an das Kühlmedium (6), insbesondere an das gasförmiges Kühlmedium (6) oder an die Umgebungsluft, abführbar ist.

9. Stromrichter (30) mit einem Heatpipekühlkörper (1) nach einem der Ansprüche 1 bis 7 oder einer Leistungshalbleitereinheit (10) nach Anspruch 8.

10. Verfahren zur Herstellung eines Heatpipekühlkörpers (1) nach einem der Ansprüche 1 bis 7, wobei in einem ersten Schritt der Körper (2) oder Blockteile (24) in Blockform hergestellt werden, wobei der Kanal (3) sich in einer Ebene erstreckt, wobei in einem zweiten Schritt der Körper (2) oder die Blockteile (24) derart umgeformt oder gebogen werden, dass sich der erste Körperabschnitt (21) mit einer mäanderförmigen oder U-förmigen Struktur ergibt.

11. Verfahren nach Anspruch 10, wobei der Körper (2) aus mindestens zwei Blockteilen (24) gebildet wird.

12. Verfahren nach einem der Ansprüche 10 oder 11, wobei der Körper (2) oder die Blockteile (24) in einer Blockform mittels eines Extrusionsverfahrens, insbesondere eines Strangpressverfahrens, eines Stranggussverfahrens oder eines Spritzgussverfahrens, hergestellt wird.

13. Verfahren nach Anspruch 11, wobei der Körper (2) gefräst, gedrückt oder gepresst wird, insbesondere der Kanal (2) in die zwei Blockteile (24) gefräst, gedrückt oder gepresst wird.
